# EUROPEAN PATENT SPECIFICATION

(11) **EP 3 639 298 B1**
(45) Date of publication and mention of the grant of the patent: **05.03.2025**
(21) Application number: 18839130.4
(22) Date of filing: 06.07.2018
(51) Int. Cl.: H01L 29/786, H01L 29/423, H10B 12/00, H10B 53/20

(54) **MEMORY CELLS WHICH INCLUDE TRANSISTORS HAVING GAP CHANNEL MATERIAL**
SPEICHERZELLEN MIT TRANSISTOREN MIT SPALTKANALMATERIAL
CELLULES DE MÉMOIRE QUI COMPRENNENT DES TRANSISTORS AYANT UN MATÉRIAU DE CANAL DE GAP

(30) Priority: 27.07.2017 US 201762537842 P
(43) Date of publication of application: 22.04.2020
(73) Proprietor: Micron Technology, Inc., Boise, ID 83716 (US)
(72) Inventor: SANDHU, Gurtej, S., Boise, ID 83706 (US); ROBERTS, Martin, C., Boise, ID 83702 (US)
(74) Representative: Marks & Clerk LLP
(86) International application number: PCT/US2018/041137
(87) International publication number: WO 2019/022944

(56) References cited:
- KR-A- 20120 069 258
- US-A- 5 977 580
- US-A1- 2007 236 979
- US-A1- 2012 075 917
- US-A1- 2012 228 688
- US-A1- 2014 035 018
- US-A1- 2015 048 292
- US-A1- 2016 049 406
- US-A1- 2017 012 126
- US-B1- 9 698 272

## Description

### TECHNICAL FIELD

Memory cells which include transistors having GaP channel material.

### BACKGROUND

Memory is one type of integrated circuitry, and is used in computer systems for storing data. Memory may be fabricated in one or more arrays of individual memory cells. Memory cells may be written to, or read from, using digit lines (which may also be referred to as bitlines, data lines, sense lines, or data/sense lines) and access lines (which may also be referred to as wordlines). The digit lines may conductively interconnect memory cells along columns of the array, and the access lines may conductively interconnect memory cells along rows of the array. Each memory cell may be uniquely addressed through the combination of a digit line and an access line.

Memory cells may be volatile or nonvolatile. Nonvolatile memory cells can store data for extended periods of time including when the computer is turned off. Volatile memory dissipates and therefore is rapidly refreshed/rewritten, in many instances multiple times per second. Regardless, memory cells are configured to retain or store memory in at least two different selectable states. In a binary system, the states are considered as either a "0" or a "1". In other systems, at least some individual memory cells may be configured to store more than two levels or states of information.

Some memory cells may include a transistor in combination with a capacitor (or other suitable charge-storage device). The transistor is utilized to selective access the capacitor, and may be referred to as an access device. The capacitor may electrostatically store energy as an electric field within capacitor dielectric between two capacitor plates. The electrical state of the capacitor may be utilized to represent a memory state.

US 5,977,580 relates to a DRAM that includes a plurality of transistors parallel to each other and formed above a substrate. A bit line is perpendicular to each of the plurality of transistors, and is coupled to the transistors. A predetermined portion of each transistor is a storage node for a capacitor, and a plate surrounds the predetermined portion through a dielectric film. US9698272B1 discloses a transistor and semiconductor memory device. US2012/228688A1 discloses a memory device that is as small in area as possible and has an extremely long data retention period. US2012/075917A1 discloses a semiconductor memory device and method for driving the same.

### SUMMARY

A memory array according to the claims.

### BRIEF DESCRIPTION OF THE DRAWINGS

FIG. 1 is a diagrammatic view of a region of an example memory array.
FIG. 2 is a diagrammatic cross-sectional side view of a region of an example memory array and illustrates an example memory cell.
FIG. 2A is a diagrammatic cross-sectional view along the line 2A-2A of FIG. 2.
   FIG. 3 is a diagrammatic view of a region of an example memory array.

### DETAILED DESCRIPTION OF THE ILLUSTRATED EMBODIMENTS

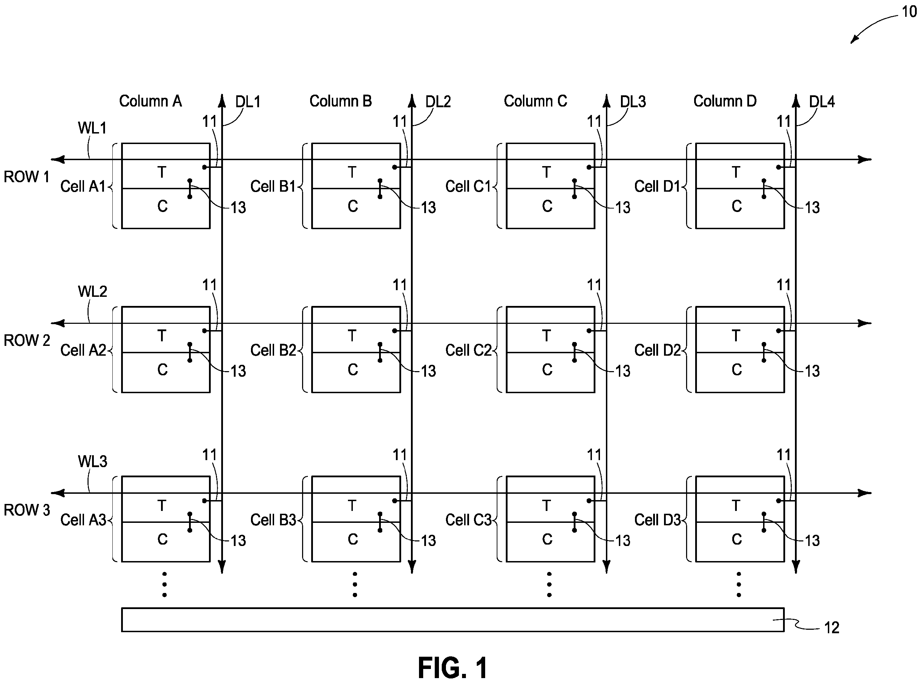

Integrated memory may be formed in a three-dimensional memory array in which memory cells are vertically stacked one atop another. A region of an example three-dimensional memory array 10 is diagrammatically illustrated in FIG. 1. The memory array 10 comprises a first set of conductive lines extending vertically relative to an underlying supporting substrate 12, and a second set of conductive lines extending horizontally across the memory array. The conductive lines of the first set are labeled as digit lines DL1, DL2, DL3, and DL4; and the conductive lines of the second set are labeled as wordlines WL1, WL2 and WL3. The digit lines extend along columns of the memory array, with such columns being labeled as Column A, Column B, Column C and Column D. The wordlines extend along rows of the memory array, with such rows being labeled as Row 1, Row 2 and Row 3.

The memory array 10 comprises a plurality of memory cells, with each of the memory cells being uniquely addressed by one of the digit lines and one of the wordlines. The memory cells are labeled with descriptors indicating their locations relative to the rows and columns. For instance, the memory cell along Column A and Row 1 is labeled as Cell A1; the memory cell along Column B and Row 1 is labeled as Cell B1, etc. The memory cells include a transistor (T) in combination with a capacitor (C). Each transistor has a source/drain region coupled with an associated digit line (such coupling is diagrammatically illustrated with lines 11), and has another source/drain region coupled with a storage node of the capacitor (such coupling is diagrammatically illustrated with lines 13). Each transistor also has a gate coupled with a wordline passing across the transistor.

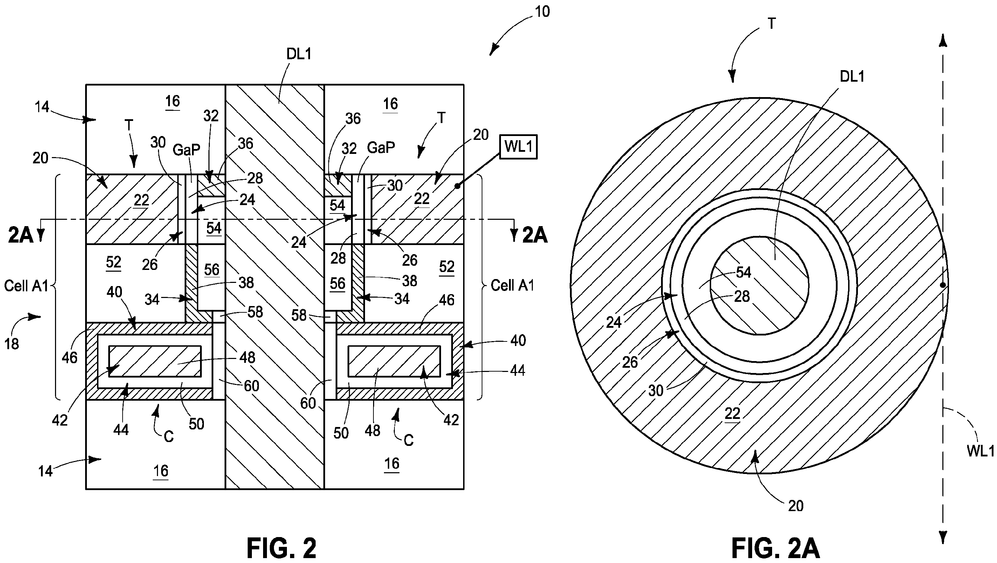

The transistors will include channel material between the source/drain regions (with example channel material being shown and described below with reference to FIG. 2). In some embodiments, it is recognized that it can be advantageous to utilize gallium phosphide (GaP) as channel material within the vertically-stacked memory cells of the memory array 10 of FIG. 1. The GaP may provide advantages of a large bandgap, reasonable mobility of charge carriers, and compatibility with a silicon lattice. In some aspects, it is recognized that GaP may be advantageous over silicon and other semiconductor materials for utilization in the channel regions of the vertically-stacked memory cells due to the large bandgap and the reasonable mobility of charge carriers. Accordingly, it is recognized that it may be advantageous to incorporate GaP into the transistors of the vertically-stacked memory cells.

The GaP channel material may be advantageous in numerous configurations of vertically-stacked memory cells. An example configuration is described with reference to FIG. 2. Specifically, FIG. 2 shows an expanded region of a portion of the memory array 10 comprising the Cell A1. The other memory cells of memory array 10 may have a configuration substantially identical to that of the illustrated Cell A1; with the term "substantially identical" meaning identical to within reasonable tolerances of fabrication and measurement.

The illustrated region of memory array 10 includes the digit line DL1 extending vertically through the memory cell A1. Insulative regions 14 are above and below the memory cell A1, with such insulative regions comprising insulative material 16. The insulative material 16 may comprise any suitable composition or combination of compositions; and in some embodiments may comprise, consist essentially of, or consist of silicon dioxide.

In some embodiments, the memory cell A1 may be considered to be part of a memory tier 18 which is vertically between insulative tiers corresponding to the insulative regions 14. The tier 18 may also include the memory cells B1, C1 and D1 of FIG. 1, with such memory cells being horizontally displaced relative to the memory cell A1; and additional memory tiers may be vertically displaced relative to the tier 18, with such additional tiers comprising the memory cells A2, A3, B2, B3, etc., of FIG. 1.

Continuing the description of FIG. 2, the memory cell A1 includes the transistor T and the capacitor C. The transistor T has a gate 20 comprising a conductive gate material 22. The conductive gate material 22 may comprise any suitable electrically conductive materials, such as, for example, one or more of various metals (e.g., titanium, tungsten, cobalt, nickel, platinum, etc.), metal-containing compositions (e.g., metal silicide, metal nitride, metal carbide, etc.), and/or conductively-doped semiconductor materials (e.g., conductively-doped silicon, conductively-doped germanium, etc.).

The transistor T also includes a channel region 24 spaced from the gate 20 by a dielectric region 26.

The channel region reform comprises channel material 28, which is indicated to include GaP. The GaP may be doped to an appropriate threshold voltage with any suitable dopant, and may be n-type or p-type. Example dopants which may be utilized include arsenic, zinc, sulfur, tellurium, silicon, germanium, tin, etc.

The dielectric region 26 comprises dielectric material 30. The dielectric material 30 may comprise any suitable composition or combination of compositions; and in some embodiments may comprise, consist essentially of, or consist of one or more of silicon dioxide, aluminum oxide, hafnium oxide, etc. In some embodiments, the dielectric material 30 may be referred to as gate dielectric material.

The transistor T includes a first source/drain region 32 and a second source/drain region 34, with the first and second source/drain regions being vertically displaced relative to one another. The source/drain regions 32 and 34 comprise conductive materials 36 and 38, respectively. Such conductive materials may include any suitable composition or combination of compositions; such as, for example, conductively-doped semiconductor material (e.g., conductively-doped silicon), metal (e.g., titanium, tungsten, cobalt, nickel, platinum, etc.), metal-containing compositions (e.g., metal silicide, metal nitride, metal carbide, etc.), etc. Generally, the source/drain regions 32 and 34 do not comprise GaP, but instead comprise conductive material compatible with GaP and suitable for utilization as source/drain regions in a transistor configuration utilizing GaP as channel material. The conductive materials 36 and 38 of source/drain regions 32 and 34 may be the same as one another in some embodiments, and in other embodiments may be different from one another. For instance, in some embodiments the first source/drain region 32 may comprise conductively-doped silicon, and the second source/drain region 34 may comprise metal and/or one or more metal containing compositions.

The digit line DL1 may comprise any suitable electrically conductive material(s), such as, for example, one or more of various metals (e.g., titanium, tungsten, cobalt, nickel, platinum, ruthenium, etc.), metal-containing compositions (e.g., metal silicide, metal nitride, metal carbide, etc.), and/or conductively-doped semiconductor materials (e.g., conductively-doped silicon, conductively-doped germanium, etc.). The first source/drain region 32 is electrically coupled with the digit line DL1, and in the shown embodiment is directly against the digit line DL1.

In some embodiments, there may be no source/drain region 32 contact as shown, but instead GaP 28 may extend to directly contact the digit line DL1. Also, in some embodiments, the digit line DL1 may be constructed to comprise an outer layer of one material (e.g., doped silicon) and an inner core of a second material (e.g., metal or metal-containing material). A structure eliminating the shown source/drain region 32 and instead directly coupling GaP 28 to the digit line DL1 may be built with fewer process steps than the illustrated structure in some applications.

The second source/drain region 34 is electrically coupled with a first electrode (storage node) 40 of the capacitor C. The capacitor C also includes a second electrode 42, and a capacitor dielectric region 44 between the first and second electrodes 40 and 42.

The electrodes 40 and 42 comprise conductive materials 46 and 48, respectively. Such conductive materials may be any suitable materials, such as, for example, one or more of various metals (e.g., titanium, tungsten, cobalt, nickel, platinum, etc.), metal-containing compositions (e.g., metal silicide, metal nitride, metal carbide, etc.), and/or conductively-doped semiconductor materials (e.g., conductively-doped silicon, conductively-doped germanium, etc.). The electrodes 40 and 42 may comprise a same composition as one another, or may comprise different compositions relative to one another.

The capacitor dielectric region 44 comprises dielectric material 50 (which may be referred to as capacitor dielectric material). Such dielectric material may comprise any suitable composition or combination of compositions; and in some embodiments may comprise silicon dioxide, silicon nitride, etc. In some embodiments, the capacitor dielectric material may comprise a ferroelectric material.

The gate 20 of transistor T is spaced from the first electrode 40 of capacitor C by insulative material 52. The insulative material 52 may comprise any suitable composition or combination of compositions; and in some embodiments may comprise, consist essentially of, or consist of silicon dioxide.

A segment of the channel region 24 is spaced from the digit line DL1 by insulative material 54, a segment of the source/region 38 is spaced from the digit line DL1 by insulative material 56, another segment of the source/drain region 38 is spaced from the digit line by an insulative material 58, and the capacitor C is spaced from the digit line DL1 by an insulative material 60. The insulative materials 54, 56, 58 and 60 may comprise any suitable composition(s) or combination(s) of compositions; and in some embodiments may comprise one or more of silicon dioxide, silicon nitride, etc. The insulative materials 54, 56, 58 and 60 may comprise a same composition as one another, or may comprise different compositions relative to one another. For instance, in some embodiments the insulative material 54 may comprise silicon dioxide, the insulative material 56 may comprise silicon nitride, the insulative material 58 may comprise silicon dioxide, and the insulative material 60 may comprise silicon nitride.

The transistor T and the capacitor C are each configured as a ring surrounding the digit line DL1. For instance, FIG. 2A shows a cross-section along the line 2A-2A of FIG. 2, and shows the transistor T configured as an example ring surrounding the digit line DL1. Specifically, the gate 20 is configured as an outer annular region surrounding an annular region corresponding to the gate dielectric 30, which in turn surrounds an annular region corresponding to the channel material 28, which in turn surrounds an annular region corresponding to the insulative material 54, which in turn surrounds the digit line DL1. The wordline WL1 is coupled with the transistor gate 20, with such coupling being diagrammatically illustrated in FIGS. 2 and 2A.

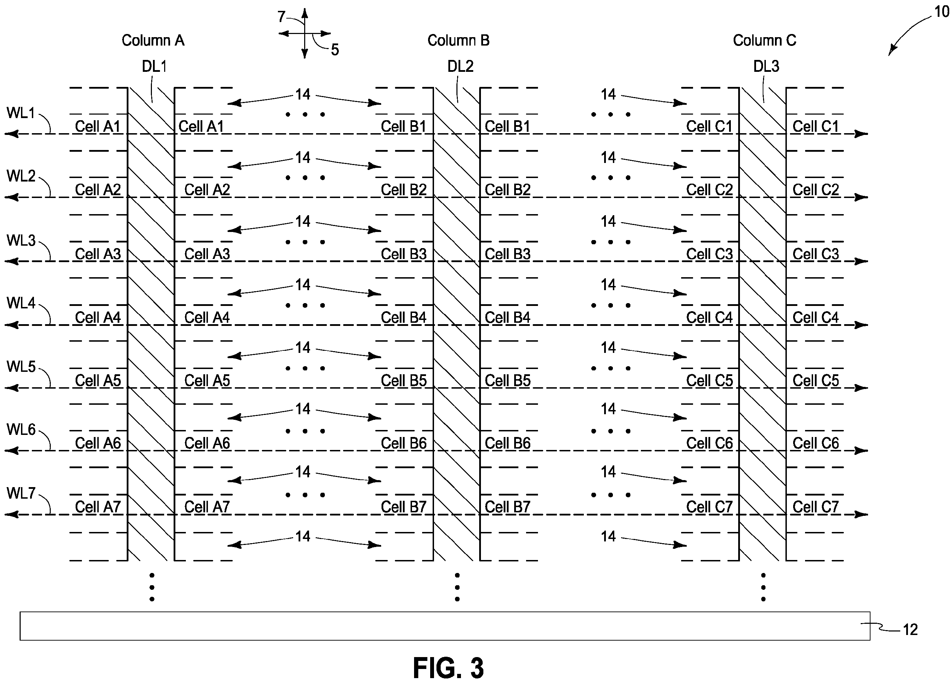

As indicated above, the memory cell A1 may be representative of a large number of substantially identical memory cells utilized in a memory array. FIG. 3 shows a region of an example memory 10 having digit lines extending along a vertical direction represented by an axis 5, and wordlines extending along a horizontal direction represented by an axis 7. The memory cell A1 is shown to be one of a plurality of substantially identical memory cells extending across the memory array, with each of the memory cells being uniquely addressed by one of the digit lines and one of the wordlines (for instance, the memory cell A1 is uniquely addressed with the digit line DL1 and the wordline WL1). Each of the memory cells may have the configuration described above with reference to FIGS. 2 and 2A, and accordingly may comprise a transistor (e.g., the transistor T of FIG. 2) configured as a ring surrounding a digit line. Each transistor comprises first and second source/drain regions (e.g., the first and second source/regions 32 and 34 of FIG. 2) spaced from one another by GaP channel material (e.g., the channel material 28 of FIG. 2), with the first and second source/drain regions being vertically displaced relative to one another. Each of the memory cells also comprises a capacitor (e.g., the capacitor C of FIG. 2) coupled with one of the source/drain regions of the transistor (e.g., coupled with the second source/drain region 34 shown in FIG. 2).

The memory array 10 of FIG. 3 may comprise any suitable number of memory cells, and in some embodiments may comprise hundreds, thousands, millions, billions, etc. of substantially identical memory cells. The memory array 10 of FIG. 3 may be the only memory array associated with a semiconductor chip, or may be one of several memory arrays associated with the chip.

The embodiments described above utilize GaP as channel material, it is recognized that it is advantageous to utilize any suitable channel material that comprises GaP and has a bandgap greater than 2 electron-volts (eV) at 300 kelvin. GaP has a bandgap about 2.25 eV at 300 kelvin. The channel materials having bandgaps greater than 2 eV may be single compositions, or multiple compositions.

The structures discussed above may be incorporated into electronic systems. Such electronic systems may be used in, for example, memory modules, device drivers, power modules, communication modems, processor modules, and application-specific modules, and may include multilayer, multichip modules. The electronic systems may be any of a broad range of systems, such as, for example, cameras, wireless devices, displays, chip sets, set top boxes, games, lighting, vehicles, clocks, televisions, cell phones, personal computers, automobiles, industrial control systems, aircraft, etc.

Unless specified otherwise, the various materials, substances, compositions, etc. described herein may be formed with any suitable methodologies, either now known or yet to be developed, including, for example, atomic layer deposition (ALD), chemical vapor deposition (CVD), physical vapor deposition (PVD), etc.

The terms "dielectric" and "insulative" may be utilized to describe materials having insulative electrical properties. The terms are considered synonymous in this disclosure. The utilization of the term "dielectric" in some instances, and the term "insulative" (or "electrically insulative") in other instances, may be to provide language variation within this disclosure to simplify antecedent basis within the claims that follow, and is not utilized to indicate any significant chemical or electrical differences.

The particular orientation of the various embodiments in the drawings is for illustrative purposes only, and the embodiments may be rotated relative to the shown orientations in some applications. The descriptions provided herein, and the claims that follow, pertain to any structures that have the described relationships between various features, regardless of whether the structures are in the particular orientation of the drawings, or are rotated relative to such orientation.

The cross-sectional views of the accompanying illustrations only show features within the planes of the cross-sections, and do not show materials behind the planes of the cross-sections, unless indicated otherwise, in order to simplify the drawings.

When a structure is referred to above as being "on" or "against" another structure, it can be directly on the other structure or intervening structures may also be present. In contrast, when a structure is referred to as being "directly on" or "directly against" another structure, there are no intervening structures present.

Structures (e.g., layers, materials, etc.) may be referred to as "extending vertically" to indicate that the structures generally extend upwardly from an underlying base (e.g., substrate). The vertically-extending structures may extend substantially orthogonally relative to an upper surface of the base, or not.

Some embodiments include a memory array having vertically-stacked memory cells. Each of the memory cells includes a transistor coupled with a charge-storage device, and each of the transistors has channel material with a bandgap greater than 2 electron-volts.

Some embodiments include a memory array having a first set of conductive lines extending along a vertical direction, and a second set of conductive lines extending along a horizontal direction. The memory array includes a plurality of memory cells, with each of the memory cells being uniquely addressed by combination of one of the conductive lines from the first set and one of the conductive lines from the second set. Each of the memory cells includes a transistor having GaP channel material.

Some embodiments include a memory array having digit lines extending along a vertical direction and wordlines extending along a horizontal direction. The memory array includes a plurality of memory cells, with each of the memory cells being uniquely addressed by combination of one of the digit lines and one of the wordlines. Each of the memory cells includes a transistor which has GaP channel material. The transistors are configured as rings surrounding the digit lines. Each of the transistors has first and second source/drain regions spaced from one another by the GaP channel material. The first source/drain regions are coupled with the digit lines. Each of the memory cells includes a capacitor coupled with the second source/drain region of the transistor of the memory cell.

## Claims

1. A memory array (10) comprising vertically-stacked memory cells; each of the memory cells comprising a vertical transistor (T) having channel material (28) comprising GaP and having a bandgap greater than 2 electron-volts, eV;
the transistor (T) having first and second source/drain regions (32, 34) which are vertically displaced relative to one another, and wherein the channel material (28) extends between the vertically-displaced first and second source/drain regions (32, 34); and
a capacitor (C) coupled with the transistor (T);
a first set of conductive lines (DL1, DL2, DL3, DL4) extending along a vertical direction, the capacitor (C) being configured as a ring surrounding one of the conductive lines of the first set;
a second set of conductive lines (WL1, WL2, WL3) extending along a horizontal direction; and
each of the memory cells being uniquely addressed by combination of one of the conductive lines from the first set and one of the conductive lines from the second set.

2. The memory array of claim 1 wherein the first and second source/drain regions (32, 34) have different compositions relative to one another.

3. The memory array of claim 2 wherein the first source/drain regions (32) comprise conductively-doped silicon and the second source/drain regions (34) comprise metal.

4. The memory array of claim 1 wherein the conductive lines of the first set are digit lines (DL1, DL2, DL3, DL4) and the conductive lines of the second set are wordlines (WL1, WL2, WL3).

5. The memory array of claim 4 wherein the transistors (T) are configured as rings surrounding the digit lines (DL1, DL2, DL3, DL4).

6. The memory array of claim 1 wherein the first and second source/drain regions (32, 34) have a same composition as one another.

7. The memory array of claim 6 wherein the first and second source/drain regions (32, 34) comprise metal.

8. The memory array of claim 4 wherein the GaP channel material of each of the transistors (T) is configured as a ring surrounding an associated one of the digit lines (DL1, DL2, DL3, DL4), with said ring being spaced from said associated one of the digit lines (DL1, DL2, DL3, DL4) by insulative material.

## Patentansprüche

1. Speichermatrix (10), umfassend vertikal gestapelte Speicherzellen;
wobei jede der Speicherzellen einen vertikalen Transistor (T) umfasst, der ein Kanalmaterial (28) aufweist, das GaP umfasst und eine Bandlücke von mehr als 2 Elektronenvolt (eV) aufweist;
wobei der Transistor (T) erste und zweite Source/Drain-Regionen (32, 34) aufweist, die vertikal relativ zueinander versetzt sind, und wobei sich das Kanalmaterial (28) zwischen den vertikal versetzten ersten und zweiten Source/Drain-Regionen (32, 34) erstreckt; und
einen mit dem Transistor (T) gekoppelten Kondensator (C);
wobei sich ein erster Satz von Leiterbahnen (DL1, DL2, DL3, DL4) in vertikaler Richtung erstrecken, wobei der Kondensator (C) als ein eine der Leiterbahnen des ersten Satzes umgebender Ring konfiguriert ist;
wobei sich ein zweiter Satz von Leiterbahnen (WL1, WL2, WL3) in horizontaler Richtung erstreckt; und
wobei jede der Speicherzellen durch eine Kombination aus einer der Leiterbahnen des ersten Satzes und einer der Leiterbahnen des zweiten Satzes eindeutig adressiert wird.

2. Speichermatrix nach Anspruch 1, wobei die ersten und zweiten Source-/Drain-Regionen (32, 34) unterschiedliche Zusammensetzungen in Bezug aufeinander aufweisen.

3. Speichermatrix nach Anspruch 2, wobei die ersten Source-/Drain-Regionen (32) leitfähig dotiertes Silizium umfassen und die zweiten Source-/Drain-Regionen (34) Metall umfassen.

4. Speichermatrix nach Anspruch 1, wobei die Leiterbahnen des ersten Satzes Digitleitungen (DL1, DL2, DL3, DL4) sind und die Leiterbahnen des zweiten Satzes Wortleitungen (WL1, WL2, WL3) sind.

5. Speichermatrix nach Anspruch 4, wobei die Transistoren (T) als die Digitleitungen (DL1, DL2, DL3, DL4) umgebende Ringe konfiguriert sind.

6. Speichermatrix nach Anspruch 1, wobei die ersten und zweiten Source-/Drain-Regionen (32; 34) dieselbe Zusammensetzung aufweisen.

7. Speichermatrix nach Anspruch 6, wobei die ersten und zweiten Source-/Drain-Regionen (32, 34) Metall umfassen.

8. Speichermatrix nach Anspruch 4, wobei das GaP-Kanalmaterial jedes der Transistoren (T) als ein eine zugeordnete der Digitleitungen (DL1, DL2, DL3, DL4) umgebender Ring konfiguriert ist, wobei der Ring von der zugeordneten der Digitleitungen (DL1, DL2, DL3, DL4) durch isolierendes Material beabstandet ist.

## Revendications

1. Réseau de mémoire (10) comprenant des cellules de mémoire empilées verticalement ;
chacune des cellules de mémoire comprenant un transistor vertical (T) comportant un matériau de canal (28) comprenant du GaP et présentant une largeur de bande interdite supérieure à 2 électronvolts (eV) ;
le transistor (T) comportant des première et seconde régions de source/drain (32, 34) qui sont décalées verticalement l'une par rapport à l'autre, et dans lequel le matériau de canal (28) s'étend entre les première et seconde régions de source/drain décalées verticalement (32, 34) ; et
un condensateur (C) couplé au transistor (T) ;
un premier ensemble de lignes conductrices (DL1, DL2, DL3, DL4) s'étendant suivant une direction verticale, le condensateur (C) étant configuré en tant qu'anneau entourant l'une des lignes conductrices du premier ensemble ;
un second ensemble de lignes conductrices (WL1, WL2, WL3) s'étendant suivant une direction horizontale ; et
chacune des cellules de mémoire étant adressée de façon unique par une combinaison de l'une des lignes conductrices issue du premier ensemble et de l'une des lignes conductrices issue du second ensemble.

2. Réseau de mémoire selon la revendication 1, dans lequel les première et seconde régions de source/drain (32, 34) présentent des compositions mutuellement différentes.

3. Réseau de mémoire selon la revendication 2, dans lequel les premières régions de source/drain (32) comprennent du silicium dopé de manière conductrice et les secondes régions de source/drain (34) comprennent un métal.

4. Réseau de mémoire selon la revendication 1, dans lequel les lignes conductrices du premier ensemble sont des lignes de chiffres (DL1, DL2, DL3, DL4) et les lignes conductrices du second ensemble sont des lignes de mots (WL1, WL2, WL3).

5. Réseau de mémoire selon la revendication 4, dans lequel les transistors (T) sont configurés en tant qu'anneaux entourant les lignes de chiffres (DL1, DL2, DL3, DL4).

6. Réseau de mémoire selon la revendication 1, dans lequel les première et seconde régions de source/drain (32, 34) présentent une même composition l'une que l'autre.

7. Réseau de mémoire selon la revendication 6, dans lequel les première et seconde régions de source/drain (32, 34) comprennent un métal.

8. Réseau de mémoire selon la revendication 4, dans lequel le matériau de canal GaP de chacun des transistors (T) est configuré en tant qu'anneau entourant l'une associée des lignes de chiffres (DL1, DL2, DL3, DL4), ledit anneau étant espacé de ladite ligne associée des lignes de chiffres (DL1, DL2, DL3, DL4) par un matériau isolant.
